# FASCICULE DE BREVET EUROPEEN

(11) **EP 2 452 162 B1**
(45) Date de publication et mention de la délivrance du brevet: **17.12.2014**
(21) Numéro de dépôt: 10728673.4
(22) Date de dépôt: 05.07.2010
(51) Int. Cl.: G01D 18/00, H04B 3/46, H04B 3/02, G06F 1/28, B64D 43/00

(54) **CIRCUIT D'EXCITATION DE CAPTEURS A COURANT CONTINU**
ERREGERSCHALTUNG FÜR GLEICHSTROMSENSOREN
EXCITATION CIRCUIT FOR DC SENSORS

(30) Priorité: 07.07.2009 FR 0903338
(43) Date de publication de la demande: 16.05.2012
(73) Titulaire: SAGEM DEFENSE SECURITE, 92100 Boulogne Billancourt (FR)
(72) Inventeur: GENESTE, Nicolas, F-75015 PARIS (FR); ESTEVE, Gwenaël, F-75015 PARIS (FR)
(74) Mandataire: Lavialle, Bruno François Stéphane
(86) Numéro de dépôt international: PCT/EP2010/059545
(87) Numéro de publication internationale: WO 2011/003852

(56) Documents cités:
- EP-A2- 1 361 118
- SU-A1- 702 379
- US-A1- 2006 016 259

## Description

La présente invention concerne un circuit d'excitation de capteurs à courant continu comme par exemple décrit dans EP 1 361 118 A2. Ce circuit d'excitation est plus particulièrement destiné à être incorporé dans le dispositif de commande du moteur d'un aéronef.

Un tel dispositif de commande comprend un calculateur qui détermine notamment le débit de carburant en fonction de la température du moteur, des pressions dans le moteur et des états des différents composants du moteur. Le dispositif comprend à cette fin des circuits d'excitation et des circuits d'acquisition reliés à des capteurs comportant des capteurs à courant continu, tels que des sondes de température de type thermocouple et des jauges de contrainte, qui renvoient un signal continu de faible amplitude.

Dans une telle application, où une défaillance du dispositif de commande peut avoir des conséquences dramatiques pour le fonctionnement de l'aéronef, l'une des préoccupations principales est la détection des pannes et, de préférence, l'identification des composants défaillants.

Actuellement, en l'absence d'une telle identification, l'ensemble capteur et circuits associés est changé lorsqu'une défaillance est détectée. Il en résulte des coûts importants.

Cette détection et cette identification pourraient être réalisées au moyen de composants électroniques complexes. Or, la fiabilité des composants électroniques diminue avec la complexité tandis que leur coût augmente avec celle-ci.

Un but de l'invention est de fournir un moyen simple permettant de détecter et d'identifier des défaillances dans un circuit d'excitation.

A cet effet, on prévoit, selon l'invention, un circuit d'excitation d'au moins un capteur à courant continu, le circuit comportant un contrôleur numérique de régulation relié à une chaîne principale et à une boucle de régulation, la chaîne principale comprenant un convertisseur numérique / analogique relié au capteur par une voie amplifiée directe et une voie amplifiée inversée pour émettre des signaux d'excitation du capteur comportant une composante continue en mode différentiel, la chaîne de régulation comprenant un convertisseur analogique / numérique reliés aux voies amplifiées, le circuit comprenant une chaîne de surveillance qui est relié au contrôleur en parallèle du convertisseur pour émettre des signaux en fonction d'une composante alternative des signaux prélevés sur les voies amplifiées, le calculateur numérique étant agencé pour injecter une sinusoïde en mode commun sur les signaux d'excitation et pour analyser des signaux en sortie de la chaîne de surveillance et des signaux en sortie du convertisseur analogique / numérique.

L'analyse des signaux de la chaîne de surveillance et de la chaîne de régulation permet de révéler des défaillances et d'identifier celles-ci. La sinusoïde ne perturbe pas le fonctionnement du capteur alimenté en mode différentiel mais va servir à la détection et à l'identification des défaillances. Ainsi, la chaîne de surveillance permet de vérifier le fonctionnement des amplificateurs par détection du signal en sortie de ceux-ci, le signal étant alternatif en fonctionnement normal et continu en cas de défaillance. La chaîne de régulation permet elle aussi la détection et l'identification de défaillances. Ainsi, en fonctionnement normal, la chaîne de régulation ne voit qu'un signal continu mais en cas de court-circuit d'une des voies amplifiées à la masse, la sinusoïde disparaît de cette voie amplifiée mais reste sur l'autre voie amplifiée de sorte que la sinusoïde apparaît sur la chaîne de régulation. La chaîne de régulation permet en outre de détecter la présence d'un circuit ouvert (le courant est alors nul) ou un court-circuit différentiel (la tension est alors nulle). La détection des défaillances est ainsi réalisée avec des composants simples. La régulation numérique permet en outre d'avoir des impédances entre le calculateur numérique et le capteur, permettant de protéger le calculateur numérique de la foudre sans recourir à des dispositifs parafoudres spécifiques, tels que ceux du type TRANSORB, alors qu'avec une régulation analogique classique la présence de telles impédances entraînerait des chutes de tension préjudiciables au fonctionnement du capteur et imposerait donc le recours aux dispositifs parafoudre spécifiques.

De préférence, la boucle de régulation comprend une voie de régulation en courant et une voie de régulation en tension reliées au convertisseur analogique / numérique par un commutateur de connexion sélective.

Le circuit peut de la sorte fonctionner en source de tension ou en source de courant selon les capteurs qui lui sont reliés.

D'autres caractéristiques et avantages de l'invention ressortiront à la lecture de la description qui suit de modes de réalisation particuliers non limitatifs de l'invention.

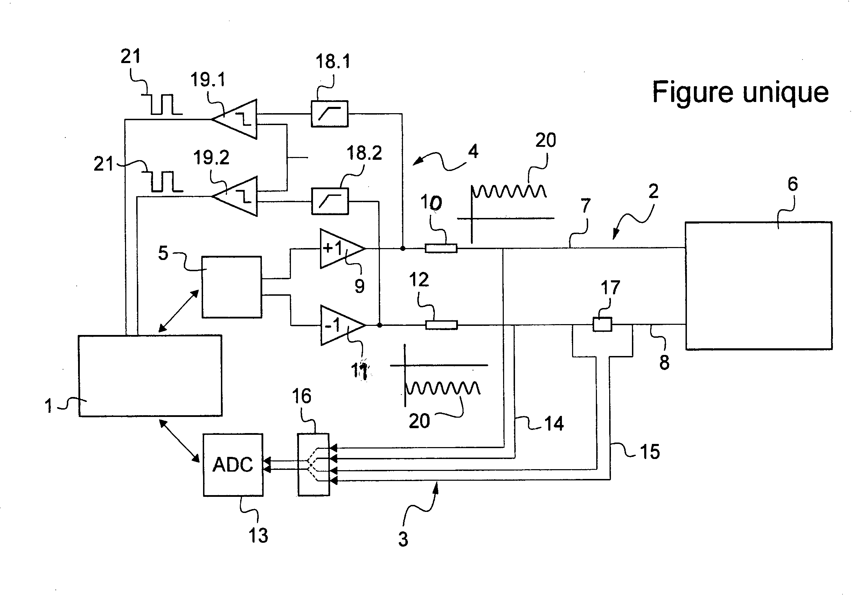

Il sera fait référence à la figure unique annexée représentant schématiquement le circuit conforme à l'invention.

Le circuit d'excitation conforme à l'invention est plus particulièrement destiné à être utilisé dans un dispositif de commande d'un moteur thermique d'aéronef à partir d'informations provenant de capteurs incorporés au moteur et d'instructions du pilote de l'aéronef. Le dispositif de commande actionne un organe de réglage du débit de carburant introduit dans la chambre de combustion du moteur.

Ces capteurs comportent des capteurs à courant continu devant être excités soit à tension fixe comme des capteurs de pression (tels que des jauges de contraintes excitées en tension) soit à courant fixe comme des capteurs de température (tels que des sondes platine excitées en courant). Le circuit d'excitation conforme au mode de réalisation préféré de l'invention est agencé pour exciter indifféremment l'un ou l'autre de ces types de capteurs.

Le circuit d'excitation comporte un contrôleur numérique de régulation 1 (ou coeur numérique) relié à une chaîne principale, à une boucle de régulation et à une chaîne de surveillance qui portent respectivement la référence générale 2, 3 et 4.

La chaîne principale 2 comprend un convertisseur numérique / analogique 5 relié au capteur 6 par une voie amplifiée directe 7 et une voie amplifiée inversée 8. La voie amplifiée directe 7 comporte un amplificateur 9, direct, et une impédance 10 qui sont montés en série entre le convertisseur numérique / analogique 5 et le capteur 6. La voie amplifiée inversée 8 comporte un amplificateur 11, inverseur, et une impédance 12 qui sont montés en série entre le convertisseur numérique / analogique 5 et le capteur 6. Les impédances 10 et 12 assurent une protection parafoudre du calculateur numérique de régulation 1.

La boucle de régulation 3 comprend un convertisseur analogique / numérique 13 relié aux voies amplifiées 7 et 8 en aval des impédances 10, 12 par une boucle de régulation en tension 14 et une boucle de régulation en courant 15 qui sont reliées au convertisseur analogique / numérique 13 par un commutateur de connexion sélective 16 ou multiplexeur. La boucle de régulation en tension 14 comporte deux voies reliées au commutateur de connexion sélective 16 et respectivement à une des voies amplifiées 7, 8. La boucle de régulation en courant comprend deux voies reliées au commutateur de connexion sélective 16 et à la voie amplifiée 8 de part et d'autre d'une résistance 17 qui est montée en série sur la voie 8 pour former un convertisseur courant / tension. Le commutateur de connexion sélective 16 permet de relier au convertisseur analogique / numérique 13 au choix la boucle de régulation en courant ou la boucle de régulation en tension en fonction du type de capteur 6 raccordé aux voies amplifiées 7, 8.

La chaîne de surveillance 4 comprend deux voies 4.1, 4.2 reliées chacune au calculateur numérique de régulation 1 et à une des voies amplifiées 7, 8 entre l'amplificateur 9, 11 et l'impédance 10, 12. Chacune des voies comprend un filtre passe-haut 18.1, 18.2 et un comparateur 19.1, 19.2 du signal de sortie du filtre passe-haut 18.1, 18.2 à une référence. Les comparateurs 19 et les filtres passe-haut 18 sont reliés au calculateur numérique de régulation 1 en parallèle du convertisseur numérique / analogique 5 pour comparer la référence et une composante alternative des signaux prélevés sur les voies amplifiées 7, 8 en sortie des amplificateurs 9, 11. Les filtres passe-haut 18 permettent d'éliminer la composante continue des signaux prélevés sur les voies amplifiées 7, 8.

Le calculateur numérique de régulation 1 est agencé pour émettre sur les voies amplifiées 7, 8 des signaux d'excitation du capteur 6 en mode différentiel, et pour analyser des signaux en sortie du convertisseur analogique / numérique 13.

Les signaux d'excitation sont déterminés soit à partir d'une mesure de tension ou de courant, selon le capteur 6, effectuée en sortie du convertisseur analogique / numérique 13. La régulation numérique autorise une polyvalence du circuit d'excitation et il est possible de changer le capteur 6 sans changer le circuit d'excitation.

Le circuit d'excitation est agencé pour détecter et identifier des pannes, à savoir des pannes internes (pannes des composants actifs du circuit d'excitation comme les convertisseurs et les amplificateurs) et des pannes externes (circuit ouvert, court-circuit différentiel et court-circuit à la masse).

Le calculateur numérique de régulation 1 est agencé à cette fin pour injecter une sinusoïde 20 en mode commun dans les signaux d'excitation émis sur les voies amplifiées 7, 8 et pour analyser des signaux en sortie des comparateurs 19.

La sinusoïde ne perturbe pas le capteur qui, du fait du mode différentiel n'est soumis qu'à la composante continue des signaux d'excitation.

L'analyse des signaux en sortie des comparateurs 19 permet de détecter les pannes internes. En effet, en fonctionnement normal, les signaux en sortie des comparateurs sont normalement des signaux alternatifs de type sinusoïde, ici des signaux carrés 21. Ces signaux résultent de la comparaison et du filtrage des signaux prélevés en sortie des amplificateurs 9 et 11. En cas de panne interne, le signal en sortie des comparateurs 19 est constant.

L'analyse des signaux en sortie du convertisseur analogique / numérique 13 permet de détecter et d'identifier les pannes externes. La boucle de régulation 4 permet une mesure de tension entre les impédances 10, 12 et le capteur 6. Le signal en sortie des comparateurs 19 permet de déterminer la tension en sortie des amplificateurs 9, 11. Il est dès lors possible de calculer la chute de tension provoquée par les impédances et l'intensité tirée par le capteur 6. Une trop faible intensité voire une intensité nulle révèle un circuit ouvert tandis qu'une trop forte intensité et une tension nulle révèlent un court-circuit différentiel. Le calculateur numérique compare ainsi les signaux en sortie de la chaîne de surveillance et les signaux en sortie de la boucle de régulation pour détecter une différence de tension et d'intensité.

La détection des courts-circuits à la masse n'est pas évidente dans les avions car la masse n'est pas au même potentiel partout. La boucle de régulation 3 permet ici de détecter ces courts-circuits à la masse. En fonctionnement normal, la boucle de régulation 3 ne voit que la composante continue, la composante alternative s'éliminant du fait de sa présence sur les deux voies amplifiées. Or, si une des voies amplifiées est en court-circuit avec la masse, la sinusoïde disparaît sur cette voie mais reste sur l'autre voie amplifiée. La composante alternative est alors apparente sur la boucle de régulation 4. Le convertisseur analogique / numérique 13 récupère la composante continue par moyennage (filtrage passe-bas) et la composante alternative par démodulation numérique. La démodulation numérique est une démodulation numérique synchrone avec une fréquence correspondant à la fréquence de la sinusoïde pour éliminer le bruit. Si le signal sinusoïdal résultant de la démodulation synchrone a une amplitude supérieure à un seuil, il y a un court-circuit à la masse. Le signe de la sinusoïde est également vérifié par le calculateur numérique de régulation 1 car il permet de déterminer quelle voie est à la masse.

Le tableau ci-après synthétise la logique de détection des différentes pannes possibles.

| | MESURE TENSION V | MESURE COURANT I | SIGNAUX COMPARATEURS |
|---|---|---|---|
| Fonctionnement normal | V ≠ 0 | I ≠ 0 | Signal carré |
| Circuit ouvert | V ≠ 0 | I = 0 | Signal carré |
| Court-circuit différentiel | V = 0 | I ≠ 0 | Signal carré |
| Court-circuit à la masse | V = 0 + signal alternatif | I ≠ 0 + signal alternatif | Signal carré |
| Panne driver | V ≠ tension nominale | I ≠ courant nominal | Signal continu |

Bien entendu, l'invention n'est pas limitée au mode de réalisation décrit mais englobe toute variante entrant dans le champ de l'invention telle que définie par les revendications.

En particulier, le circuit d'excitation conforme à l'invention peut être utilisé avec un ou plusieurs capteurs à tension constante et/ou à courant constant.

Bien que l'invention ait été décrite dans une application aéronautique, l'invention est applicable à l'excitation de tout type de détecteur à courant continu à des fins de régulation de moteur ou de tout autre type de commande.

Le circuit d'excitation peut ne comprendre qu'une boucle de régulation en tension ou une boucle de régulation en courant.

## Revendications

1. Circuit d'excitation d'au moins un capteur (6) à courant continu, comportant un calculateur numérique (1) de régulation relié à une chaîne principale (2) et à une boucle de régulation (3), la chaîne principale (2) comprenant un convertisseur numérique / analogique (5) relié au capteur (6) par une voie amplifiée directe (7) et une voie amplifiée inversée (8) pour émettre des signaux d'excitation du capteur (6) comportant une composante continue en mode différentiel, la boucle de régulation (3) comprenant un convertisseur analogique / numérique (13) reliés aux voies amplifiées (7, 8) le circuit comprenant une chaîne de surveillance (4) qui est relié au calculateur (1) en parallèle du convertisseur (13) pour émettre des signaux en fonction d'une composante alternative des signaux prélevés sur les voies amplifiées (7, 8), le calculateur numérique (1) étant agencé pour injecter une sinusoïde (20) en mode commun sur les signaux d'excitation et pour analyser des signaux en sortie de la chaîne de surveillance (4) et des signaux en sortie du convertisseur analogique / numérique (5).

2. Circuit selon la revendication 1, dans lequel la chaîne de surveillance (4) comprend des comparateurs (19) pour comparer une référence à la composante alternative.

3. Circuit selon la revendication 2, dans lequel la chaîne de surveillance (4) comprend des filtres (18) pour éliminer la composante continue des signaux prélevés sur les voies amplifiées.

4. Circuit selon la revendication 1, dans lequel le convertisseur analogique / numérique (13) récupère la composante continue des signaux d'excitation par moyennage et la composante alternative par démodulation numérique synchrone avec une fréquence de la sinusoïde (20) et le calculateur numérique (1) est agencé pour comparer le signal sinusoïdal résultant de la démodulation synchrone à un seuil et vérifier le signe de ce signal sinusoïdal.

5. Circuit selon la revendication 1, dans lequel le calculateur numérique (1) est agencé pour comparer les signaux en sortie de la chaîne de surveillance (4) et les signaux en sortie de la boucle de régulation (3) pour détecter une différence de tension et d'intensité.

6. Circuit selon la revendication 1, dans lequel la boucle de régulation (3) comprend une voie de régulation en courant et une voie de régulation en tension reliées au convertisseur analogique / numérique (13) par un commutateur de connexion sélective (16).

## Patentansprüche

1. Erregerschaltung für mindestens einen Gleichstromsensor (6), umfassend einen digitalen Regelungsrechner (1), der mit einem Hauptkreis (2) und mit einem Regelkreis (3) verbunden ist, wobei der Hauptkreis (2) einen Digital-Analog-Umsetzer (5) umfasst, der mit dem Sensor (6) über einen Kanal (7) mit direkter Verstärkung und einen Kanal (8) mit invertierender Verstärkung verbunden ist, um Anregungssignale zur Anregung des Sensors (6) auszusenden, die einen Gleichanteil im Gegentakt umfassen, wobei der Regelkreis (3) einen Analog-Digital-Umsetzer (13) umfasst, der mit den verstärkten Kanälen (7, 8) verbunden ist, wobei die Schaltung einen Überwachungskreis (4) umfasst, der mit dem Rechner (1) parallel zum Wandler (13) verbunden ist, um Signale in Abhängigkeit eines Wechselanteils der Signale auszusenden, die auf den verstärkten Kanälen (7, 8) abgegriffen werden, wobei der Digitalrechner (1) derart ausgebildet ist, dass er eine Sinusschwingung (20) im Gleichtakt in die Anregungssignale einkoppelt und Ausgangsignale des Überwachungskreises (4) und Ausgangssignale des Analog-Digital-Umsetzers (5) analysiert.

2. Schaltung nach Anspruch 1, wobei der Überwachungskreis (4) Komparatoren (19) umfasst, um einen Referenzwert mit dem Wechselanteil zu vergleichen.

3. Schaltung nach Anspruch 2, wobei der Überwachungskreis (4) Filter (18) umfasst, um den Gleichanteil der Signale, die auf den verstärkten Kanälen abgegriffen werden, zu beseitigen.

4. Schaltung nach Anspruch 1, wobei der Analog-Digital-Umsetzer (13) den Gleichanteil der Anregungssignale durch Mittelwertbildung und den Wechselanteil durch eine digitale zu einer Frequenz der Sinusschwingung (20) synchrone Demodulation gewinnt, und der Digitalrechner (1) derart ausgebildet ist, dass er das Sinussignal, das aus der Synchrondemodulation resultiert, mit einem Schwellwert vergleicht und das Vorzeichen dieses Sinussignals überprüft.

5. Schaltung nach Anspruch 1, wobei der Digitalrechner (1) derart ausgebildet ist, dass er die Ausgangssignale des Überwachungskreises (4) und die Ausgangssignale des Regelkreises (3) vergleicht, um einen Spannungs- und Intensitätsunterschied zu erfassen.

6. Schaltung nach Anspruch 1, wobei der Regelkreis (3) eine Strom-Regelstrecke und eine Spannungs-Regelstrecke umfasst, die mit dem Analog-Digital-Umsetzer (13) über einen Schalter (16) zur selektiven Verbindung verbunden sind.

## Claims

1. A circuit for exciting at least one direct current (DC) sensor (6), the circuit comprising a digital regulation controller (1) connected to a main system (2) and to a regulation loop (3), the main system (2) comprising a digital-to-analog converter (DAC) (5) connected to the sensor (6) via a non-inverted amplified path (7) and via an inverted amplified path (8) in order to send sensor (6) excitation signals including a DC component in differential mode, the regulation loop (3) including an analog-to-digital converter (ADC) (13) connected to the amplified paths (7, 8), the circuit including a monitoring system (4) that is connected to the controller (1) in parallel with the converter (13) in order to send signals as a function of an alternating current (AC) component of the signals taken from the amplified paths (7, 8), the digital controller (1) being arranged to inject a sinewave (20) in common mode into the excitation signals and to analyze signals output by the monitoring system (4) and signals output by the ADC (5).

2. A circuit according to claim 1, wherein the monitoring system (4) includes comparators (19) for comparing the AC component with a reference.

3. A circuit according to claim 2, wherein the monitoring system (4) includes filters (18) for eliminating the DC components from the signals taken from the amplified paths.

4. A circuit according to claim 1, wherein the ADC (13) recovers the DC components from the excitation signals by averaging and their AC components by digital demodulation that is synchronous with a frequency of the sinewave (20), and the digital controller (1) is arranged to compare the sinewave signal that results from the synchronous demodulation with a threshold and to verify the sign of the sinewave signal.

5. A circuit according to claim 1, wherein the digital controller (1) is arranged to compare the output signals from the monitoring system (4) and the output signals from the regulation loop (3) in order to detect a voltage and current difference.

6. A circuit according to claim 1, wherein the regulation loop (3) comprises a current regulation path and a voltage regulation path, which paths are connected to the ADC (13) via a selective connection switch (16).
